# EUROPEAN PATENT APPLICATION

(11) **EP 3 012 977 A1**
(43) Date of publication of application: **27.04.2016**
(21) Application number: 14190277.5
(22) Date of filing: 24.10.2014
(51) Int. Cl.: H03K 17/567, H03K 17/12

(54) **Method for switching a semiconductor module, semiconductor module and half-bridge**

(71) Applicant: ABB Technology AG, 8050 Zürich (CH)
(72) Inventor: Rahimo, Munaf, 5619 Uezwil (CH); Canales, Francisco, 5405 Baden-Dättwil (CH); Minamisawa, Renato, 5200 Brugg (CH)
(74) Representative: ABB Patent Attorneys

(57) **Abstract**

A method for switching a semiconductor module (10, 10a, 10b) with a reverse conducting insulated gate bipolar transistor (12) connected in parallel to a wide band-gap MOSFET switch (14), a semiconductor module (10, 10a, 10b), and a half bridge are proposed. The method comprises the steps of determining a nominal switching time (tₙ) of the semiconductor module (10, 10a, 10b) and a gate switching time (t_{g}), which is prior to the nominal switching (tₙ) time by a predefined delay time (t_{d}), and applying a negative gate voltage at the gate switching time (t_{g}) to a gate terminal (20) of the reverse conducting insulated gate bipolar transistor (12) and to a gate terminal (38) of the wide band-gap MOSFET switch (14), such that the wide band-gap switch (14) is switched to an off-state, in which off-state an internal reverse conducting diode of the wide band-gap switch (14) is turned off, and a current through the wide band-gap switch (14) is diverted through an internal reverse conducting diode of the insulated gate bipolar transistor (12) during the predefined delay time (t_{d}). This way, reverse recovery losses may be reduced.

## Description

### FIELD OF THE INVENTION

The invention relates to the field of power semiconductor electronics. In particular the invention relates to a method for switching a power semiconductor module, to a power semiconductor module, and to a half-bridge comprising power semiconductor modules.

### BACKGROUND OF THE INVENTION

Semiconductor switches based on wide band-gap (WBG) materials, in particular unipolar materials, such as e.g. Silicon Carbide (SiC) and Gallium Nitride (GaN), provide low switching losses due to inherent advantages of these materials, such as e.g. low leakage currents at high operational temperatures and low losses at low currents.

On the other hand, bipolar Silicon (Si) based switches, such as e.g. insulated gate bipolar transistors (IGBT), reverse conducting insulated gate bipolar transistors (RC-IGBT), and bi-mode insulated gate transistors (BIGT), may further provide various advantages compared to wide band gap switches. For example, bipolar Si based switches may provide good protection characteristics including high current and series connection high voltage capability, a reliable short circuit failure mode, good short circuit capability due to a relatively high saturation current of bipolar Si based switches, a low avalanche breakdown, and good surge current capability in diode mode.

US 2014/0185346 A1 relates to a hybrid power device comprising first and second switching devices containing first and second unequal band-gap semiconductor materials, wherein the switching devices are three or more terminal switching devices of different type.

EP 0 443 155 B1 relates to a switchgear for switching on and off, having a driver for switching MOS-FET semiconductors, which are connected in parallel, and IGBT power semiconductors.

### DESCRIPTION OF THE INVENTION

It is an object of the invention to provide an operational method with low losses for gate controlling and/or switching a semiconductor module comprising an insulated gate bipolar transistor connected in parallel with a wide band-gap (WBG) switch, in particular when operating the semiconductor module in a diode mode and/or during reverse recovery.

This object is achieved by the subject-matter of the independent claim. Further exemplary embodiments are evident from the dependent claims and the following description.

An aspect of the invention relates to a method for switching and/or gate controlling a semiconductor module with a reverse conducting insulated gate bipolar transistor connected in parallel to a wide band-gap switch. The wide band-gap switch may for instance be a metal-oxide-semiconductor field-effect-transistor (MOSFET) wide band-gap switch.

The semiconductor module may particularly be a high-power semiconductor module adapted for processing currents above approximately 10 A and/or voltages above approximately 100 V.

According to an embodiment of the invention, the method comprises determining a nominal switching time of the semiconductor module and a gate switching time, which is prior to the nominal switching time by a predefined delay time. Here and in the following, both the gate switching time and the nominal switching time may denote a certain point and/or instant in time, whereas the predefined delay time may denote a certain period and/or interval of time, by which the gate switching time precedes the nominal switching time.

Further, the method comprises applying a negative gate voltage at the gate switching time to a gate terminal of the insulated gate bipolar transistor and to a gate terminal of the wide band-gap switch, such that the wide band-gap switch is switched to an off-state, in which off-state an internal reverse conducting diode of the wide band-gap switch is turned off, and a current through the wide band-gap switch is diverted through an internal reverse conducting diode of the insulated gate bipolar transistor during at least a part of the predefined delay time.

In general, by electrically connecting the insulated gate bipolar transistor and the wide band-gap switch in parallel, a hybrid semiconductor module may be provided allowing to benefit from various advantageous properties of both the insulated gate bipolar transistor and the wide band-gap switch. The main advantages of the parallel arrangement are, apart from the lower cost, low conduction losses over the full current range, low switching losses, low thermal resistance, soft turn-off performance, high switching robustness, and improved fault current protection. This may result in optimum properties of the entire semiconductor module in terms of thermal, conduction (losses), switching (losses, softness), and fault conditions performance (surge, short circuit, short circuit failure mode "SCFM"), overall performance, and costs compared to a full wide band-gap module.

However, one important target in optimizing the hybrid semiconductor module may be to reduce cost by using a minimum number of wide band-gap switches, while maintaining advantages provided by such devices in terms of performance. Hence, in order to eliminate a need for separate diodes in the semiconductor module, employing both reverse conducting devices, i.e. the insulated gate bipolar transistor and the wide band-gap switch, and controlling their operational mode may be feasible to achieve such target.

Both the insulated gate bipolar transistor and the wide band-gap switch may be operated in a diode mode and/or a freewheeling mode prior to switching. In the diode mode current may flow through the internal and/or integrated diodes of the insulated gate bipolar transistor and/or the wide band-gap switch in a reverse direction with respect to a forward conducting mode of the insulated gate bipolar transistor and/or the wide band-gap switch. On the other hand, from the point of view of the diodes employed in the semiconductor module, current is flowing in forward direction during diode mode and in reverse direction during the forward conducting mode of the insulated gate bipolar transistor and/or the wide band-gap switch. Thus, the inventive method focuses on a gate control of the hybrid combination or hybrid semiconductor module during forward conduction (from the diodes' point of view) and reverse recovery when operating in diode mode. Accordingly, here and in the following any current through any diode of one of the insulated gate bipolar transistor and the wide band-gap switch, may refer to a reverse conducting mode of the insulated gate bipolar transistor and/or the wide band-gap MOSFET switch. Further, the term "forward current" for any diode may be used synonymously with the term "diode current".

By applying the negative gate voltage to the gate terminal of the wide band-gap switch prior to reverse recovery and within the predefined delay time, the wide band-gap switch, more precisely the internal diode of the wide band-gap switch, may enter an in-active, non-conducting and/or blocking state, in which any bipolar action may be avoided and nearly no conduction in forward direction of the diode may be experienced. Apart from that, by applying the negative gate signal to the gate terminal of the insulated gate bipolar transistor, the insulated gate bipolar transistor may ensure that any current, which would at least partially be conducted through the internal diode of the wide band-gap switch in case a positive gate signal would be applied to its gate terminal, is diverted and/or bypassed through the internal diode of the insulated gate bipolar transistor. This is mainly due to a very low on-state under a negative gate signal, thus avoiding any current diversion to the internal diode of the wide band-gap switch under reverse recovery conditions.

Moreover, by well-defining and optimizing the delay time, low reverse recovery losses may be obtained due to a short time for establishing full plasma "excess carrier" concentrations in the insulated gate bipolar transistor, which in turn may minimize a reverse recovery charge and hence losses.

Furthermore, the insulated gate bipolar transistor may ensure good surge current capability under fault conditions.

The term "negative gate voltage" may refer to a gate voltage with negative polarity and/or a negative potential with respect to a ground. The negative gate voltage may further refer to a negative gate signal and/or a negative gate pulse, i.e. a signal and/or pulse of negative voltage applied to the respective gate terminal.

The term "nominal switching time" may refer to the point in time, in which the module and/or the module's insulated gate bipolar transistor and/or the modules wide band-gap switch enters revers recovery. The nominal switching time may for instance be determined according to various boundary conditions, which may depend on an application of the semiconductor module. For example, if the semiconductor module is utilized in a DC-to-AC-converter, a so-called power inverter, the nominal switching time may be determined according to a zero-crossing of an output current of the inverter.

The term "gate switching time" may refer to the point in time, in which the gate signal and/or the voltage applied to the respective gate terminals is altered, such as e.g. reversed and/or switched from a positive gate voltage to a negative gate voltage.

Further, the term "delay time" may refer to the period and/or interval in time, at least during which the negative gate voltage is applied prior to the nominal switching time. However, the negative gate voltage may also be applied after the nominal switching time. In this context, the delay time may thus also denote the time difference between the nominal switching time and the gate switching time.

The "gate terminal" may refer for instance to a planar gate terminal or a trench gate terminal of the insulated gate transistor and/or the wide band-gap switch.

Apart from the gate terminal the insulated gate bipolar transistor may comprise an emitter or emitter terminal and a collector or collector terminal, which emitter and collector may also be planar terminals. The wide band-gap switch may, additionally to the gate terminal, comprise a source or source terminal and a drain or drain terminal, which source and drain may be planar terminals.

Another aspect of the invention relates to a semiconductor module comprising an insulated gate bipolar transistor, a wide band-gap switch, and a controller. The controller is adapted to carry out the steps of the method for switching the semiconductor module as described in the above and in the following.

Yet another aspect of the invention relates to half bridge and/or a half bridge arrangement comprising two semiconductor modules as described in the above and in the following, which semiconductor modules are connected in series.

It has to be understood that features of the method as described in the above and in the following may be features of the semiconductor module and/or the half bridge as described in the above and in the following. Vice versa, features of the semiconductor module and/or the half bridge as described in the above and in the following may be features of the method.

According to an embodiment of the invention, the predefined delay time is selected such that a reverse recovery charge of the internal diode of the insulated gate bipolar transistor is minimized during the predefined delay time. Preferably, the reverse recovery charge is nearly entirely reduced and/or removed. By minimizing the reverse recovery charge during the delay time as much as possible, reverse recovery losses may be minimized, which may in turn result in an optimization of an overall performance of the semiconductor module.

According to an embodiment of the invention, the delay time is below 15 µs.

According to a further embodiment of the invention, the delay time is below or equal to 10 µs. The delay time may be selected and/or chosen as short as possible in order to increase the module's overall performance, but long enough for minimizing the reverse recovery charge in order to minimize reverse recovery losses.

According to an embodiment of the invention, the gate voltage is positive before the negative gate voltage is applied at the gate switching time. While applying the positive gate voltage prior to switching according to the invention, the semiconductor module is operated in a reverse conducting diode mode, synonymously called freewheeling mode. In diode mode (i.e. during diode conduction in forward direction from the diodes' point of view) the positive gate voltage and/or a positive gate signal applied at both the gate terminal of the insulated gate bipolar transistor and the wide band-gap switch results in sharing of the forward current by both the insulated gate bipolar transistor and the wide band-gap switch. Therein, a current sharing ratio for the given gate voltage may depend on forward characteristics of the diodes of the insulated gate bipolar transistor and the wide band-gap switch, respectively, i.e. the reverse conducting characteristics of the insulated gate bipolar transistor and the wide band-gap switch. To be more precise, the current sharing ration may depend on an on-state voltage, which in turn may depend on the following design parameters of the semiconductor module and/or of the insulated gate bipolar transistor and/or the wide band-gap switch: an operational temperature; the applied gate voltage; a design of the wide band-gap switch, such as e.g. a drift region and a Metal-Oxide-Semiconductor (MOS) cell design; a lifetime control of the insulated gate bipolar transistor and an injection efficiency of n⁺ shorts; and an area ratio of the insulated gate bipolar transistor and the wide band-gap switch.

According to an embodiment of the invention, the negative gate voltage is below a threshold voltage of at least one of the reverse conducting insulated gate bipolar transistor and the wide band gap switch. The threshold voltage may denote a threshold gate voltage required to create an inversion channel in a MOS cell of at least one of the reverse conducting insulated gate bipolar transistor and the wide band-gap switch. The negative gate voltage may for instance be below -10 V and preferably equal to or below -15 V.

According to an embodiment of the invention, the internal reverse conducting diode of the wide band-gap switch is a MOSFET channel diode, also called MOS channel diode. Such MOS channel diode may advantageously be utilized for switching the semiconductor module according to the inventive method, because any bipolar action of the diode may be avoided during diode mode and/or reverse recovery. However, the wide band-gap switch may also comprise an integrated bipolar diode, which may be used as internal reverse conducting diode of the wide band-gap switch, but preferably avoided due to the high associated wide band-gap built-in voltage (> 2.6 V) and not proven reliability.

According to an embodiment of the invention, the internal reverse conducting diode of the insulated gate bipolar transistor is a PIN diode, i.e. a Positive (P type), -Intrinsic-Negative (N-type) diode. Such integrated internal PIN diode may have a moderate built-in voltage, e.g. approximately 0.7 V to 0.9 V, allowing reliable control with a moderate gate voltage. Further, such PIN diode may have a moderate turn-on resistance, i.e. a moderate R_{DS(on)}. Thus, the internal PIN diode may suitably be used as reverse conducting diode of the insulated gate bipolar transistor in high-voltage applications. However, the insulated gate bipolar transistor may also comprise a MOS channel diode, which may at least in principle be used as internal reverse conducting diode of the insulated gate bipolar transistor. Though, such MOS channel diode may have a rather large turn-on resistance, i.e. a rather large R_{DS(on)}, which may make such diode unsuitable for high-voltage applications.

According to an embodiment of the invention, the insulated gate bipolar transistor is a Si based bi-mode insulated gate transistor, BIGT, or a Si based reverse conducting insulated gate bipolar transistor, RC-IGBT. Such types of transistors may provide advantages in terms of an overall performance, a power rating, and/or a lifetime.

According to an embodiment of the invention, the wide band-gap switch is a voltage controlled unipolar switch, and/or the wide band-gap switch is a MOSFET. The term "voltage controlled switch" may relate to a switch and/or semiconductor device, whose output characteristics are determined and/or controlled by an electrical field depending on the voltage applied to the gate.

These and other aspects of the invention will be apparent from and elucidated with reference to the embodiments described hereinafter.

### BRIEF DESCRIPTION OF THE DRAWINGS

The subject-matter of the invention will be explained in more detail in the following text with reference to exemplary embodiments which are illustrated in the attached drawings.
Fig. 1A shows a structural illustration of a reverse conducting insulated gate bipolar transistor and a wide band-gap MOSFET switch for a semiconductor module according to an embodiment of the invention.
Fig. 1B shows a circuit diagram of a semiconductor module according to an embodiment of the invention.
Fig. 2 shows a semiconductor module according to an embodiment of the invention.
Fig. 3 shows a circuit diagram of a half bridge according to an embodiment of the invention.
Fig. 4A shows a diode current I through diodes integrated in an RC-IGBT and a SiC MOSFET of a semiconductor module versus a gate voltage U according to an embodiment of the invention.
Fig. 4B shows a diode current I through diodes integrated in an RC-IGBT and a SiC MOSFET of a semiconductor module versus a gate voltage U according to an embodiment of the invention.
Fig. 5 shows a gate voltage U and a diode current I as a function of time t during switching of a semiconductor module according to an embodiment of the invention.

The reference symbols used in the drawings, and their meanings, are listed in summary form in the list of reference symbols. In principal, identical parts are provided with the same reference symbols in the figures.

### DETAILED DESCRIPTION OF EXEMPLARY EMBODIMENTS

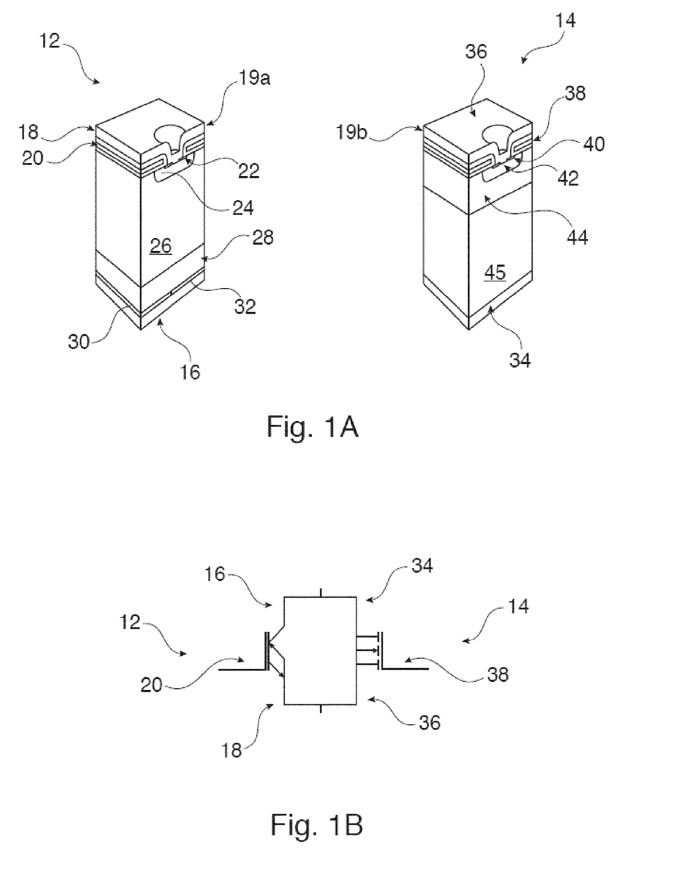

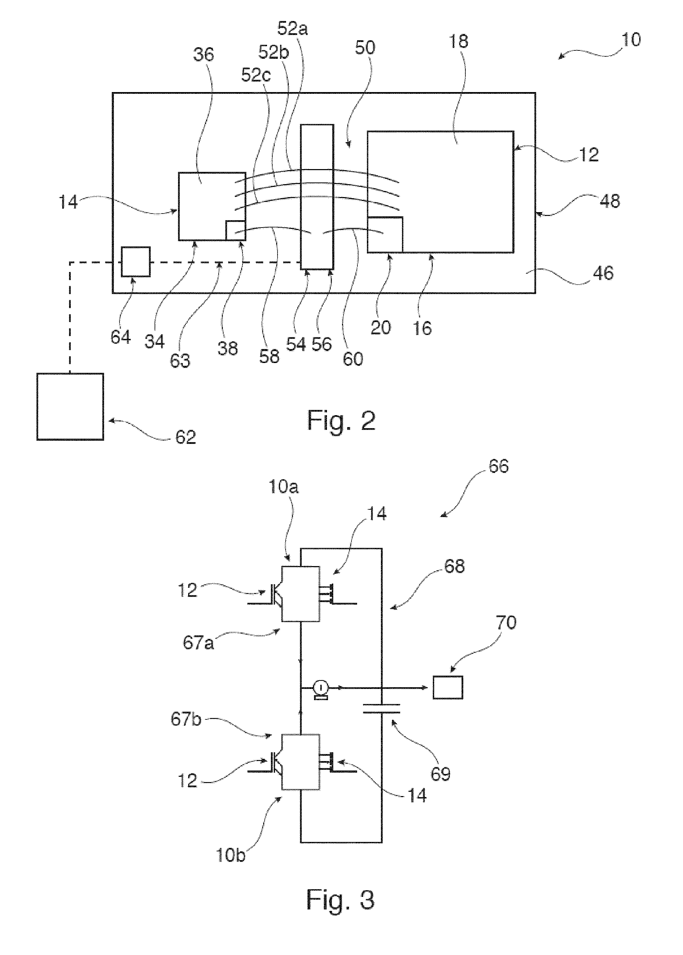

Fig. 1A shows an insulated gate bipolar transistor 12 in the form of a reverse-conducting insulated gate bipolar transistor (RC-IGBT) and a wide band-gap switch 14 in the form of a SiC MOSFET for a semiconductor module 10 (see e.g. Fig. 2). Fig. 1B shows a circuit diagram for the module 10.

On a first end the RC-IGBT 12 comprises a first planar terminal 16, which is a collector, and on a second end opposing the first end the RC-IGBT 12 comprises a second planar terminal 18, which is an emitter. Fig. 1A only shows one metal-oxide semiconductor cell 19a (MOS cell). The RC-IGBT 12 is composed of a plurality of such cells 19a. Further, neighboring the second planar terminal 18, the RC-IGBT 12 comprises a gate 20 for controlling the RC-IGBT 12. Adjacent to the gate 20, the RC-IGBT 12 comprises an n⁺- doped region 22 and a p-doped region 24, which are at least partially embedded in an n-base layer 26. The n-base layer 26 adjoins an n-buffer layer 28, which in turn adjoins a p-doped region 30 and an n-doped region 32 arranged between the n-buffer layer 28 and the first planar terminal 16, thereby providing a reverse conducting diode of the RC-IGBT 12.

The SiC MOSFET 14 comprises on a first end a first planar terminal 34, which is a drain, and a second planar terminal 36, which is a source, on a second end opposing the first end. Fig. 1A only shows one metal-oxide semiconductor cell 19b (MOS cell). The SiC MOSFET 14 is composed of a plurality of such cells 19b. The SiC MOSFET 14 further comprises a gate 38 neighboring the second planar terminal 36 for controlling the SiC MOSFET 14. Adjacent to the gate 38, the SiC MOSFET 14 comprises an n⁺-doped region 40 and a p-doped region 42, which are at least partially embedded in an n-base layer 44. Between the n-base layer 44 and the first planar terminal 34, an n+-doped layer 45 is arranged.

As depicted in the circuitry diagram of Fig. 1B, the RC-IGBT 12 is connected in parallel to the SiC MOSFET 14, wherein the respective first planar terminals 16, 34 and the second planar terminals 18, 36 are interconnected. To be more precise, the collector of the RC-IGBT 12 is connected to the drain of the SiC MOSFET 14 and the emitter of the RC-IGBT 12 is connected to the source of the SiC MOSFET 14.

Fig. 2 shows a top-view of a semiconductor module 10 according to an embodiment of the invention. The semiconductor module 10 comprises an insulated gate bipolar transistor (IGBT) 12, which may for instance be an RC-IGBT, or a BIGT, and a voltage controlled unipolar wide band-gap (WBG) switch 14, which may e.g. be a SiC MOSFET.

Both the RC-IGBT 12 and the WBG switch 14 are mounted to a side 46 of a base plate 48. The side 46 may in this context denote an outer planar surface of the base plate 48. In more detail, both the RC-IGBT 12 and the WBG switch 14 are mounted with their respective first planar terminal 16, 34 to the side 46 of the base plate 48. For instance the first planar terminals 16, 34 may be welded and/or soldered to the side 46, such that they are electrically connected via the base plate 48. For this purpose the base plate 48 may be manufactured from an electrically conductive material, such as metal and/or an appropriate alloy. The first planar terminal 16 of the RC-IGBT 12 shown in Fig. 2 is a collector or collector terminal of the IGBT 12 and the first planar terminal 34 of the WBG switch 14 is a drain or drain terminal.

On an end of the RC-IGBT 12 opposing the base plate 48, the RC-IGBT comprises a second planar terminal 18, which is an emitter or an emitter terminal. The second planar terminal 18 of the RC-IGBT 12 is electrically connected with an electrically conductive connection element 50 to a second planar terminal 36 of the WBG switch 14, which is a source or source terminal of the WBG switch 14. By connecting the collector of the RC-IGBT 12 with the drain of the WBG switch 14 via the base plate 48 and by connecting the source of the WBG switch 14 with the emitter of the RC-IGBT 12, the RC-IGBT 12 and the WBG switch 14 are electrically connected in parallel. The connection element 50 shown in Fig. 2 comprises a plurality of wire bonds 52a, 52b, 52c connecting the source of the WBG switch 14 and the emitter of the RC-IGBT 12. Alternatively or additionally, the connection element 50 may comprise a ribbon bond for connecting the second planar terminals 18, 36 of the WBG switch 14 and the RC-IGBT 12, respectively.

However, in order to employ a parallel connection of these elements, it is also possible to mount the emitter of the RC-IGBT 12 and the source of the WBG switch 14 to the side 46 of the base plate 48 and connect the drain of the WBG switch 14 and the collector of the RC-IGBT 12 with the connection element 50.

The first planar terminals 16, 34 and the second planar terminals 18, 36 of the RC-IGBT 12 and the WBG switch 14, respectively, may also each comprise a pad of electrically conductive material in order to provide an optimum electrical connection, i.e. there might an emitter pad, a collector pad, a source pad, and/or a drain pad provided at the respective first planar terminals 16, 34 and/or the second planar terminals 18, 36 of the RC-IGBT 12 and/or the WBG switch 14.

The semiconductor module 10 further comprises a gate pad 54, which is insulated mounted to the side 46 of the base plate 48 in juxtaposition and/or between the RC-IGBT 12 and the WBG switch 14. Between the gate pad 54 and the base plate 48 an insulation layer 56 is arranged, which is adapted to insulate the gate pad 54 and the base plate 48. The insulation layer 56 may for instance comprise a film of insulating material and/or an insulating spacer. The insulation layer 56 may for instance be glued, welded, and/or soldered to the base plate 48 and the gate pad 54 may for instance be glued, welded, and/or soldered to the insulation layer 56. The gate pad 54 is electrically connected to a gate 38 of the WBG switch 14 with a first gate connection element 58. The gate pad 54 is further connected to a gate 20 of the RC-IGBT 12 with a second gate connection element 60. Thus, the gate pad 54 interconnects the gate 38 of the WBG switch 14 and the gate 20 of the RC-IGBT 12. In this context, the gate pad 54 is designed as a common gate pad allowing to simultaneously control both the WBG switch 14 and the RC-IGBT 12 via the respective gates 20, 38. However, it is also possible to utilize separate gate pads for the gates 20, 38 of the RC-IGBT 12 and the WBG switch 14, respectively. The gate connection elements 58, 60 may be one of a wire bond and a ribbon bond.

The semiconductor module 10 further comprises a controller 62 adapted, amongst others, for controlling and/or switching the semiconductor module 10, the IGBT 12 and/or the WBG switch 14. For this purpose, the controller 62 may be connected to the gate pad 54 and/or a circuitry 63 of the semiconductor module 10, which circuitry 63 may in turn be connected to the gate pad 54, and the controller 62 may be adapted for providing an appropriate gate signal and/or an appropriate gate voltage to the gate pad 54 and in turn to the gates 20, 36 of the RC-IGBT 12 and/or the WBG switch 14. However, the controller 62 may also be directly connected, e.g. by an appropriate electrical connection element, to at least one of the gates 20, 36 of the RC-IGBT 12 and/or the WBG switch 14. Further, the controller 62 may be mounted to the base plate 48 or the controller 62 may be connected via an electrical connection 64 with the circuitry 63 of the semiconductor module 10. The electrical connection 64 may be e.g. an interface of the semiconductor module.

Fig. 3 shows a circuit diagram of a half bridge or half bridge arrangement 66 according to an embodiment of the invention.

The half bridge 66 comprises a first semiconductor module 10a in a first half bridge branch 67a and a second semiconductor module 10b in a second half bridge branch 67b, which semiconductor modules 10a, 10b are connected in series via a corresponding electrical circuit 68. If not stated otherwise, each of the semiconductor modules 10a, 10b of Fig. 3 may comprises the same elements and features as the semiconductor module 10 of Fig. 2.

Further, the half bridge 66 comprises a capacitor 69. Apart from that, the half bridge 66 may also comprise an inductance.

Moreover, the half bridge 66 is connected via en electrical line to a load 70. The half bridge 66 may provide, e.g. via respective switching and/or controlling of the semiconductor modules 10a, 10b, a phase current to the load 70.

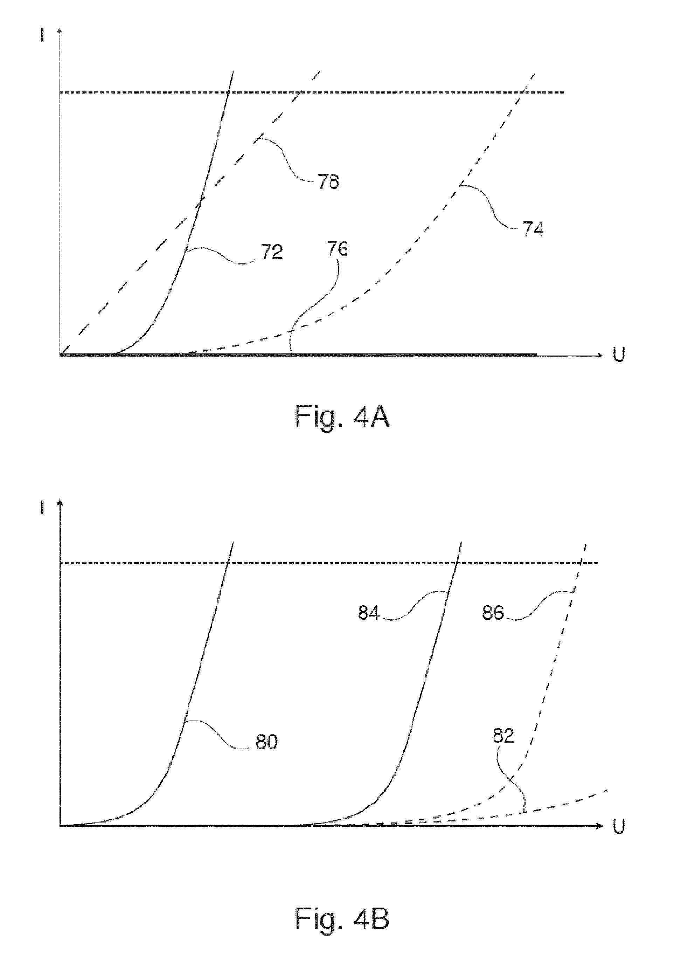

Fig. 4A and 4B each show a diode current I through diodes integrated in an RC-IGBT 12 and a SiC MOSFET 14 of a semiconductor module 10 versus a gate voltage U applied according to an embodiment of the invention.

Under diode forward biasing (i.e. in forward conducting mode from the diodes' perspective and in reverse direction of the RC-IGBT 12) the RC-IGBT 12 and the SiC MOSFET 14 have in principle four integrated diode functions. On one hand, the RC-IGBT 12 comprises an internal bipolar PIN diode with a built-in voltage of approximately 0.7 V to 0.9 V and a MOS channel diode with a built-in voltage of approximately 0 V. On the other hand, the SiC MOSFET 14 comprises an internal bipolar diode with a built-in voltage of approximately 2.8 V to 3 V and a MOS channel diode with a built-in voltage of approximately 0 V. However, from these four integrated diode functions, practically only three may be suitable for high-voltage and/or high-power applications, because the Silicon RC-IGBT 12 MOS channel diode has a large turn-on resistance, i.e. a large R_{DS(on)}.

However, it is important to point out that all the integrated diode conduction properties in terms of on-state and bipolar action are dependent on the applied gate voltage compared to standard stand-alone bipolar and unipolar diodes. Fig. 4A and 4B exemplary depict typical on-state characteristics, i.e. typical diode currents I, of the integrated diodes as a function of gate voltage U for a given temperature, wherein in Fig. 4A these characteristics are shown for the MOS channel diode of the SiC MOSFET 14 and the internal bipolar PIN diode of the Si based RC-IGBT 12 for a planar based MOS cell 19a. In contrast, Fig. 4B shows equivalent characteristics for the internal bipolar diode of the SiC MOSFET 14 and the internal bipolar PIN diode of the Si based RC-IGBT 12 with a trench based MOS cell. The trench MOS cell has a much higher on-state voltage compared to a planar RC-IGBT for a gate voltage above a threshold or built-in voltage, or in practical terms for a positively applied gate signal.

In the following it is described how the above-mentioned integrated diode functions, which may refer to operational modes of the semiconductor module 10, may be controlled in order to provide optimum diode static and dynamic performance in an inverter and/or in switching applications using the inventive method for switching the semiconductor module 10. However, due to a similar course of the respective curves shown in Figs. 4A and 4B, the following description to Fig. 4A applies to Fig. 4B and vice versa. In both Figures, solid lines correspond to a gate voltage below a threshold or a built-in voltage, whereas dashed lines correspond to a gate voltage above the threshold or built-in voltage. Further, in both figures the horizontal dashed line corresponds to a nominal current.

In Fig. 4A, curve 72 corresponds to the diode current of the RC-IGBT's 12 internal PIN diode as a function of the applied gate voltage, wherein the gate voltage is below a threshold or built-in voltage of the PIN diode, whereas curve 74 corresponds to a gate voltage above the threshold or the built-in voltage. Further, curve 76 corresponds to the diode current of the SiC MOSFET's 14 internal MOS channel diode, synonymously the internal MOSFET channel diode, as a function of the applied gate voltage, wherein the gate voltage is below a threshold or built-in voltage of the MOS channel diode. Further, curve 78 corresponds to a gate voltage above the threshold or built-in voltage.

With reference to the inventive method for switching the semiconductor module 10, a positive gate voltage may be applied to both the RC-IGBT's 12 internal bipolar PIN diode and the SiC MOSFET's 14 internal MOS channel diode. The corresponding conduction characteristics are represented by curves 74 and 78, respectively. The gate voltage applied may for example be approximately +15 V. According to the inventive method for switching the semiconductor module 10, a negative gate voltage is applied at the gate switching time. For example the negative gate voltage may be approximately -15 V. When the negative gate voltage is applied, the conduction characteristics of the diodes change to the curves 76 and 72, respectively. In other words, by reversing the gate voltage, for example from +15 V to -15 V, the internal bipolar PIN diode of the RC-IGBT 12 changes its conduction characteristics from curve 74 to 72, whereas the MOS channel diode of the SiC MOSFET 14 changes its conduction characteristics from curve 78 to 76. In analogy to Ohm's law, this means that a resistance of the internal MOS channel diode of the SiC MOSFET 14 is increased by applying the negative gate voltage, whereas a resistance of the RC-IGBT's 12 internal PIN diode is not affected much. As a consequence, nearly all the current through the MOS channel diode of the SiC MOSFET 14 is diverted and/or bypassed through the PIN diode of the RC-IGBT 12, thereby reducing a reverse recovery charge and hence reverse recovery losses.

It may be mentioned here that the SiC MOSFET 14 internal PIN diode may preferably not experience any conduction, i.e. avoiding bipolar action, during diode conduction and remains in-active. This may be aided by a high built-in voltage of the SiC PIN diode and/or by a shorted PIN diode with high on-state voltage due to a positive gate signal.

Similarly, referring to Fig. 4B, a positive gate voltage may be applied to both the RC-IGBT's 12 internal bipolar trench based PIN diode and the SiC MOSFET's 14 internal bipolar PIN diode. The corresponding conduction characteristics are represented by curves 82 and 86, respectively. The gate voltage applied may for example be approximately +15 V. According to the inventive method for switching the semiconductor module 10, a negative gate voltage, e.g. -15 V, is applied at the gate switching time. When the negative gate voltage is applied, the conduction characteristics of the diodes change to the curves 80 and 84, respectively. In other words, by reversing the gate voltage, for example from +15 V to -15 V, the internal bipolar trench based PIN diode of the RC-IGBT 12 changes its conduction characteristics from curve 82 to 80, whereas the internal bipolar PIN diode of the SiC MOSFET 14 changes its conduction characteristics from curve 86 to 84.

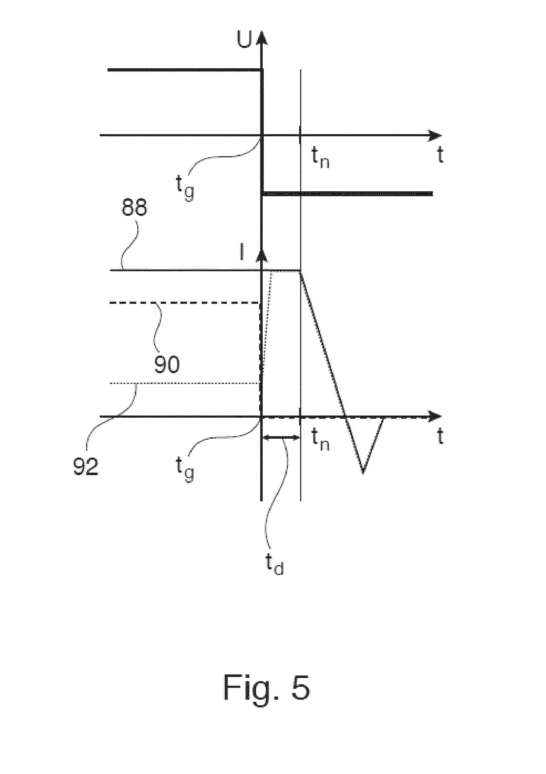

Fig. 5 shows a gate voltage U and a diode current I as a function of time t during switching of a semiconductor module according to an embodiment of the invention. The semiconductor module being switched may for instance be the semiconductor module 10 of Fig. 2 and/or at least one of the semiconductor modules 10a, 10b of the half bridge of Fig. 3. Thus, the diode current corresponds to a (forward) current through an internal diode of the RC-IGBT 12 and an internal diode of the SiC MOSFET 14. The gate voltage U and the diode current I as a function of time t depicted in Fig. 5 are intended to illustrate steps of the inventive method for switching the semiconductor module 10.

In a first step, a nominal switching time tₙ is determined. The nominal switching time may for instance be determined according to various boundary conditions, which may depend on an application of the half bridge 66 and/or the semiconductor module 10. For example, if the half bridge 66 is utilized in a DC-to-AC-converter, a so-called power inverter, the nominal switching time tₙ may be determined according to a zero-crossing of an output current of the inverter.

Further, a gate switching time t_{g} is determined, which is prior to the nominal switching time by a certain delay time t_{d}. The delay time t_{d} may in this context denote a time difference between the nominal switching time tₙ and the gate switching time t_{g}. The delay time t_{d} may be below 15 µs, and preferably below or equal to 10 µs.

At the gate switching time t_{g} a negative gate voltage is applied to the gate 20 of the RC-IGBT 12 and the gate 38 of the SiC MOSFET 14, whereas the gate voltage is positive prior to the gate switching time t_{g}. For example, the gate voltage may be reversed at the gate switching time t_{g}, for instance from +10 V to -10 V, and preferably from +15 V to -15 V.

As described above, applying a positive gate voltage during diode mode of the semiconductor module 10a to the gates 20, 38 of the RC-IGBT 12 and the SiC MOSFET 14 results in sharing of the forward current in the RC-IGBT 12 and the SiC MOSFET 14 depending on the forward characteristics or conduction characteristics of the respective diode for the given gate voltage, as illustrated in Figs. 4A and 4B.

By applying the negative voltage at the gate switching time t_{g}, the SiC MOSFET 14 is switched to an off-state, in which off-state the internal reverse conducting diode, i.e. the internal bipolar diode and/or the MOS channel diode, is turned off, and a total current 88 through the SiC MOSFET 14 is diverted through at least one internal reverse conducting diode of the RC-IGBT 12, i.e. the internal bipolar PIN diode and/or the MOS channel diode, at least during the predefined delay time t_{d} for reverse recovery. In Fig. 5 a total diode current 88 through the semiconductor module 10 is illustrated as solid line, whereas the current through the SiC MOSFET's 14 internal diode is illustrated as dashed line 90 and the current through the RC-IGBT's 12 internal diode is illustrated as dotted line 92. In more detail, due to a very low on-state under the negative gate voltage applied at and after the gate switching time t_{g}, the RC-IGBT 12 may ensure that nearly all of the total current 88 is diverted and/or bypassed through its internal diode, thus avoiding any current diversion to the SiC MOSFET's 14 internal diode under reverse recovery conditions, i.e. after the nominal switching time tₙ, in which the RC-IGBT 12 may be in a reverse recovery state. By minimizing the delay time t_{d} below or equal to 10 µs, low reverse recovery losses may be obtained due to a short time for establishing full plasma "excess carrier" concentrations in the RC-IGBT 12, which may minimize the reverse recovery charge and hence reverse recovery losses.

Further, to obtain best performance, operational and design parameters may be optimized to cover full operational modes with respect to current densities and/or temperatures.

While the invention has been illustrated and described in detail in the drawings and the foregoing description, such illustration and description are to be considered illustrative or exemplary and not restrictive; the invention is not limited to the disclosed embodiments. Other variations to the disclosed embodiments can be understood and effected by those skilled in the art and practicing the claimed invention, from a study of the drawings, the disclosure, and the appended claims. In the claims, the word "comprising" does not exclude other elements or features, and the indefinite article "a" or "an" does not exclude a plurality. The mere fact that certain measures are recited in mutually different dependent claims does not indicate that a combination of these measures cannot be used to advantage. Any reference signs in the claims are not to be construed to as limiting the scope.

### LIST OF REFERENCE SYMBOLS

- 10, 10a, 10b: semiconductor module
- 12: insulated gate bipolar transistor
- 14: wide band-gap switch
- 16: first terminal of IGBT
- 18: second terminal of IGBT
- 19a: MOS cell of IGBT
- 19b: MOS cell of WBG switch
- 20: gate of IGBT
- 22: n+-doped region
- 24: p-doped region
- 26: n-base layer
- 28: n-buffer layer
- 30: p-doped region
- 32: n-doped region
- 34: first terminal WBG switch
- 36: second terminal WBG switch
- 38: gate of WBG switch
- 40: n+-doped region
- 42: p-doped region
- 44: n-base layer
- 45: n+ doped region
- 46: side of base plate
- 48: base plate
- 50: connection element
- 52a,b,c: wire bond
- 53: ribbon bond
- 54: gate pad
- 56: insulation layer
- 58, 60: gate connection element
- 62: controller
- 63: circuitry
- 64: electrical connection
- 66: half bridge
- 67a, 67b: half bridge branch
- 68: electrical circuit
- 69: capacitor
- 70: load
- 72: current of RC-IGBT PIN diode below threshold
- 74: current of RC-IGBT PIN diode above threshold
- 76: current of SiC MOSFET channel diode below threshold
- 78: current of SiC MOSFET channel diode above threshold
- 80: current of RC-IGBT trench based PIN diode below threshold
- 82: current of RC-IGBT trench based PIN diode above threshold
- 84: current of SiC MOSFET bipolar PIN diode below threshold
- 86: current of SiC MOSFET bipolar PIN diode above threshold
- 88: total current
- 90: SiC MOS current
- 92: RC-IGBT current

## Claims

1. A method for switching a semiconductor module (10, 10a, 10b) with a reverse conducting insulated gate bipolar transistor (12) connected in parallel to a wide band-gap switch (14), the method comprising the steps of:
determining a nominal switching time (tₙ) of the semiconductor module (10, 10a, 10b) and a gate switching time (t_{g}), which is prior to the nominal switching (tₙ) time by a predefined delay time (t_{d}); and
applying a negative gate voltage at the gate switching time (t_{g}) to a gate terminal (20) of the insulated gate bipolar transistor (12) and to a gate terminal (38) of the wide band-gap switch (14),
such that the wide band-gap switch (14) is switched to an off-state, in which off-state an internal reverse conducting diode of the wide band-gap switch (14) is turned off, and a current through the wide band-gap switch (14) is diverted through an internal reverse conducting diode of the insulated gate bipolar transistor (12) during the predefined delay time (t_{d}).

2. The method according to claim 1,
wherein the predefined delay time (t_{d}) is selected such that a reverse recovery charge of the internal diode of the insulated gate bipolar transistor (12) is minimized during the predefined delay time (t_{d}).

3. The method according to one of claims 1 and 2,
wherein the delay time (t_{d}) is below 15 µs.

4. The method according to one of the preceding claims,
wherein the delay time (t_{d}) is below or equal to 10 µs.

5. The method according to one of the preceding claims,
wherein the gate voltage is positive before the negative gate voltage is applied at the gate switching time (t_{g}).

6. The method according to one of the preceding claims,
wherein the negative gate voltage is below a threshold voltage of at least one of the reverse conducting insulated gate bipolar transistor and the wide band gap switch.

7. The method according to one of the preceding claims,
wherein the internal reverse conducting diode of the wide band-gap switch (14) is a MOSFET channel diode.

8. The method according to one of the preceding claims,
wherein the internal reverse conducting diode of the insulated gate bipolar transistor (12) is a PIN diode.

9. The method according to one of the preceding claims,
wherein the insulated gate bipolar transistor (12) is a Si based BIGT or a Si based RC-IGBT.

10. The method according to one of the preceding claims,
wherein the wide band-gap switch (14) is a voltage controlled unipolar switch; and/or wherein the wide band-gap switch is a MOSFET.

11. The method according to one of the preceding claims,
wherein the wide band-gap switch (14) is based on silicon carbide or gallium nitride.

12. A semiconductor module (10, 10a, 10b) comprising:
an insulated gate bipolar transistor (12);
a wide band-gap switch (14); and
a controller (62),
wherein the controller (62) is adapted to carry out the steps of the method for switching the semiconductor module (10, 10a, 10b) according to one of claims 1 to 11.

13. A half bridge (66) comprising two semiconductor modules (10a, 10b) according to claim 12 connected in series.

## Amended claims

### Amended claims in accordance with Rule 137(2) EPC.

1. A method for switching a semiconductor module (10, 10a, 10b) with a reverse conducting insulated gate bipolar transistor (12) connected in parallel to a wide band-gap switch (14), the reverse conducting insulated gate bipolar transistor (12) comprises an internal bipolar PIN diode and the wide band-gap switch (14) comprises an internal MOS channel diode,
the method comprising the steps of:
determining a nominal switching time (tₙ) of the semiconductor module (10, 10a, 10b),
whereby the nominal switching time (tₙ) is the point in time, in which the internal bipolar PIN diode of the reverse conducting insulated gate bipolar transistor (12) enters reverse recovery, and a gate switching time (t_{g}), which is prior to the nominal switching (tₙ) time by a predefined delay time (t_{d}); whereby the gate switching time (t_{g}) is the point in time, in which the gate signal of the reverse conducting insulated gate bipolar transistor (12) and/or of the wide band-gap switch (14) and/or the voltage applied to the respective gate terminals of the insulated gate bipolar transistor (12) and/or of the wide band-gap switch (14) is altered, and whereby the predefined delay time (t_{d}) is the time difference between the nominal switching time (tₙ) and the gate switching time (t_{g});
when a positive gate voltage is applied to a gate terminal (20) of the reverse conducting insulated gate bipolar transistor (12) and to a gate terminal (38) of the wide band-gap switch (14) before the gate switching time (t_{g}) the internal bipolar PIN diode of the reverse conducting insulated gate bipolar transistor (12) and the internal MOS channel diode of the wide band-gap switch (14) are conducting, then applying a negative gate voltage at the gate switching time (t_{g}) to a gate terminal (20) of the reverse conducting insulated gate bipolar transistor (12) and to a gate terminal (38) of the wide band-gap switch (14), such that the internal MOS channel diode of the wide band-gap switch (14) is switched off at the gate switching time (t_{g}) and a current through the internal MOS channel diode of the wide band-gap switch (14) is diverted through the internal bipolar PIN diode of the reverse conducting insulated gate bipolar transistor (12) during the predefined delay time (t_{d}), whereby at the nominal switching time (tₙ) the internal bipolar PIN diode of the reverse conducting insulated gate bipolar transistor (12) enters reverse recovery.

2. The method according to claim 1,
wherein the predefined delay time (td) is selected such that a reverse recovery charge of the internal diode of the reverse conducting insulated gate bipolar transistor (12) is minimized during the predefined delay time (td).

3. The method according to one of claims 1 and 2,
wherein the delay time (td) is below 15 µs.

4. The method according to one of the preceding claims,
wherein the delay time (td) is below or equal to 10 µs.

5. The method according to one of the preceding claims,
wherein the negative gate voltage is below a threshold voltage of at least one of the reverse conducting insulated gate bipolar transistor and the wide band gap switch.

6. The method according to one of the preceding claims,
wherein the reverse conducting insulated gate bipolar transistor (12) is a Si based BIGT or a Si based RC-IGBT.

7. The method according to one of the preceding claims,
wherein the wide band-gap switch (14) is a voltage controlled unipolar switch; and/or
wherein the wide band-gap switch is a MOSFET.

8. The method according to one of the preceding claims,
wherein the wide band-gap switch (14) is based on silicon carbide or gallium nitride.

9. A semiconductor module (10, 10a, 10b) comprising:
a reverse conducting insulated gate bipolar transistor (12),
a wide band-gap switch (14), whereby the reverse conducting insulated gate bipolar transistor (12) is connected in parallel to the wide band-gap switch (14) and the reverse conducting insulated gate bipolar transistor (12) comprises an internal bipolar PIN diode and the wide band-gap switch (14) comprises an internal MOS channel diode,
a controller (62),
wherein the controller (62) is adapted to carry out the steps of the method for switching the semiconductor module (10, 10a, 10b) according to one of claims 1 to 8.

10. A half bridge (66) comprising two semiconductor modules (10a, 10b) according to claim 9 connected in series.
